(19) Europäisches Patentamt
European Patent Office
Office européen des brevets

(11) **EP 2 226 834 B1**

(12) **EUROPEAN PATENT SPECIFICATION**

(45) Date of publication and mention of the grant of the patent:
**29.04.2020 Bulletin 2020/18**

(51) Int Cl.:
***H01L 21/3213*** *(2006.01)*

(21) Application number: **10155710.6**

(22) Date of filing: **05.03.2010**

(54) **Method for physical force assisted cleaning with reduced damage**

Verfahren zur mit physischer Kraft unterstützten Reinigung mit verringertem Schaden

Procédé pour nettoyage assisté par force physique avec des dommages réduits

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **06.03.2009 US 158118 P**

(43) Date of publication of application:
**08.09.2010 Bulletin 2010/36**

(73) Proprietor: **IMEC VZW**
**3001 Leuven (BE)**

(72) Inventors:
• **Mertens, Paul**
**2820 Bonheiden (BE)**
• **Halder, Sandip**
**3001 Leuven (BE)**
• **Pacco, Antoine**
**3060 Bertem (BE)**
• **Janssens, Tom**
**1030 Schaerbeek (BE)**

(74) Representative: **Pronovem**
**Office Van Malderen**
**Avenue Josse Goffin 158**
**1082 Bruxelles (BE)**

(56) References cited:
EP-A2- 0 810 643          JP-A- 2007 150 164
JP-A- 2008 085 150       US-A- 6 124 214
US-A1- 2006 042 651

• **VEREECKE G ET AL: "Removal of nano-particles by mixed-fluid jet: evaluation of cleaning performance and comparison with megasonic", DIFFUSION AND DEFECT DATA. SOLID STATE DATA. PART B, SOLID STATEPHENOMENA, VADUZ, LI, vol. 134, 1 January 2008 (2008-01-01), pages 193-196, XP008143592, ISSN: 1012-0394**
• **HAGIMOTO Y ET AL: "The effective damage-free megasonic cleaning using N2 dissolved APM", ISSM 2005 IEEE INTERNATIONAL SYMPOSIUM ON SEMICONDUCTOR MANUFACTURING. CONFERENCE PROCEEDINGS (IEEE CAT. NO. 05CH37682) IEEE PISCATAWAY, NJ, USA, 2005, pages 215-218, XP002661899, ISBN: 0-7803-9143-8**

## Description

### Field of the invention

The present invention relates to methods, applicable primarily in the semiconductor industry, for liquid-based cleaning a substrate using megasonic energy. The present invention also relates to methods for reducing the damage induced by a megasonic assisted cleaning or, in general, a physical force assisted cleaning on a patterned substrate.

### Background of the invention

Semiconductor devices are employed in various systems for a wide range of applications. These devices are fabricated in a series of processing steps. The steps may include depositing material on a semiconductor wafer, patterning the material, etching selected portions of the material, doping, cleaning the semiconductor wafer and repeating one or more of these steps. Typically, up to one fifth of all processing steps involve some form of cleaning. As used herein, the term 'semiconductor wafer' includes any substrate, microelectronic device, chip or the like (e.g. micro or nano-structured surface, Micro-ElectroMechanical System or Nano-ElectroMechanical System), at any stage of fabrication, which is used to form an integrated circuit or other electronic circuitry.

Cleaning removes unwanted particles from the semiconductor wafer. As used herein, a 'particle' means any impurity, foreign particle or other material that is unwanted on a surface of the semiconductor wafer. For example, particles include organic and inorganic residues introduced by prior wafer processing steps. If not removed, particles may adversely affect device fabrication or performance. As such, the direct impact of these particles is a deterioration of manufacturing chip yield. With the chip yield being defined as the ration of the portion of working chips to the entire number of fabricated chips (working and non-working together).

The cleaning process typically involves applying a cleaning solution to the surface of the semiconductor wafer. There are various cleaning solutions that are used. By way of example, one such solution is called the 'standard clean 1' (SC1), which includes alkaline solutions of, e.g., hydrogen peroxide ($H_2O_2$) and ammonium hydroxide ($NH_4OH$) in deionised water.

Acoustic energy (sonic waves) may be applied to the cleaning solution in order to enhance the cleaning process. Sonic waves are typically produced by a transducer external to a wafer-cleaning tank. Typically waves are used with a frequency in the range of the order of tens to hundreds of kilohertz (KHz) ("ultrasonic") to the order of millions of hertz (MHz) ("megasonic"). Such acoustic waves produce acoustic cavitation. Cavitation is the formation of small bubbles. In such process bubbles can also collapse. When the bubbles oscillate or collapse, energy is imparted to particles or to the undesirable contaminants present on the substrate. The energy is typically sufficient to overcome the adhesion forces between the substrate to be cleaned and the particle/contaminants adhering to it.

One drawback of the megasonic cleaning is that the energy released when the bubbles collapse may damage the semiconductor device. This concern has become more important with device scaling, e.g. for the 45 nm technology node and beyond.

A straightforward way to reduce the damage induced by a megasonic assisted cleaning is to reduce the megasonic power. Unfortunately, a lower megasonic power level means a lower cleaning efficiency. In turn, the lower cleaning efficiency needs to be further addressed, by e.g. modifying the composition and chemistry of the liquid cleaning solution. However, when modifying the cleaning liquid, other constraints have to be taken into account, such as compatibility of the solutions used with the patterned structures, the substrate, their suitability for a megasonic process etc.

Cleaning methods are described in the following documents: VEREECKE G ET AL: "Removal of nano-particles by mixed-fluid jet: evaluation of cleaning performance and comparison with megasonic",SOLID STATE PHENOMENA, vol. 134, 2008, pages 193-196; HAGIMOTO Y ET AL: "The effective damage-free megasonic cleaning using N2 dissolved APM", IEEE, 2005, pages 215-218; EP 0 810 643 A2; US 2006/042651 A1; JP 2007 150164 A; US 6 124 214 A; JP 2008 085150 A.

### Aims of the invention

The aim of the invention is to provide a method that allows reducing the damage induced by a megasonic assisted cleaning, while keeping the megasonic power level unchanged. Reducing the damage should not affect adversely the cleaning efficiency or the compatibility of the cleaning process with the manufacturing flow.

### Summary of the invention

The invention is as defined in the claims.

## Brief description of the drawings

All drawings are intended to illustrate some aspects and embodiments of the present invention. The drawings described are only schematic and are non-limiting.

Figure 1 represents schematically a patterned substrate in contact with a cleaning solution showing (a) complete wetting (b) partial wetting.

Figure 2 represents the variation in contact angle of de-ionized water (DIW) on a Si hydrophobic substrate pre-treated with ammonia peroxide mixture (APM) with the composition $NH_4:H_2O_2:H_2O = 1:4:20$ as function of the APM-dip time.

Figure 3 represents schematically a cross section of the test patterned substrates (wafers).

Figure 4 represents the number of damage sites for hydrophobic (d04 and d06) and hydrophilic (d12 and d14) patterned wafers after applying a megasonic assisted cleaning (400KHz-3MHz, 30W) in de-ionized water DIW (d04 and d12) and, respectively in DIW with IPA addition (d06 and d14).

Figure 5 shows defect size distribution after megasonic assisted cleaning in DIW for the hydrophobic (d04) and hydrophilic (d12) substrates.

Figure 6 shows defect size distribution after megasonic assisted cleaning in DIW with IPA addition for the hydrophobic (d06) and hydrophilic (d14) substrates.

Figure 7 represents a defect map for the added defects after a megasonic cleaning : I(A) philic substrate in DIW; I(B) philic substrate in DIW + IPA; II(A) phobic substrate in DIW; II(B) phobic substrate in DIW + IPA.

Figure 8 represents the number of damage sites for hydrophobic and hydrophilic patterned wafers after applying a megasonic assisted cleaning (400KHz-3MHz) in DIW at different megasonic power settings: 30W, 15W and 10 W.

Figure 9 represents the number of damage sites for hydrophobic and hydrophilic patterned wafers after applying a megasonic cleaning (400KHz-3MHz, 30 W) in DIW (d04, d08, d12) and in DIW with IPA addition (d06, d10, d14).

Figure 10 (a) represents the number of damage sites for hydrophobic and hydrophilic patterned wafers after applying a megasonic cleaning (400KHz-3MHz) at 100W and 1200W in DIW in a batch processing tool; (b) defect size distribution for the philic wafers at 1200 W in DIW; (c) defect size distribution for the phobic wafers at 1200 W in DIW.

## Detailed Description of illustrative embodiments

In many cleaning applications, acoustic or mechanical agitation is applied to improve the cleaning performance, i.e. removal of undesired contaminants. Unfortunately the application of these types of agitation has often been found to create damage to the substrate surface. For example, in megasonic-assisted cleaning the energy released when the bubbles collapse may be great enough to damage the fine structures of the small-scale devices.

The present invention establishes surprisingly a link between the substrate surface condition (phobic/philic with respect to a certain liquid) which can be expressed also as a degree of wetting of said substrate by a liquid and the damage induced to the substrate by a physical force assisted cleaning in said liquid.

For example, if the liquid used for megasonic cleaning, referred further as "cleaning solution" or "cleaning liquid" is only partially wetting the substrate surface, it results in increased damage of the fine structures of an e.g. patterned substrate.

The method of the invention avoids damaging the structures on a patterned surface of a substrate, by first achieving substantially complete wetting of the surface prior to the onset of the mechanical or acoustic agitation. The complete wetting can be achieved either by, according to the invention, pre-treating the substrate prior to supplying the cleaning solution or, not according to the invention, at the same time with supplying the cleaning solution. According to a particular embodiment, a pre-treatment may be combined with a simultaneous supply of the cleaning liquid and an additive (see further).

In particular, if the cleaning solution is water or shows similar wetting characteristics as water, the surface needs to be made hydrophilic. The duration of the pre-treatment needs to be long enough to obtain an improvement in wetting of the substrate, preferably achieving complete wetting of the substrate. In general, whether there is a pre-treatment with the additive or whether the additive is supplied together with the cleaning liquid, the contact time between the substrate and the additive must be chosen so as to obtain the above cited substantially complete wetting of the patterned surface of the substrate. The contact time may differ as a function of the substrate type, its topology, or the type of additive used, and can be easily established by the skilled person on the basis of a particular combination of these parameters.

The method of the invention avoids damage to the patterned substrate by preventing cavitating bubbles to form or nucleate on the patterned substrate, e.g. on the fine structures of the patterned substrate. The cavitation process includes nucleation, bubble growth and collapse of the gas bubbles in an applied acoustic energy. Analogue with the cavitating bubbles in an applied acoustic energy, gas pockets/bubbles formed by a mechanical agitation in a liquid aerosol spray can damage the fine structures of a patterned substrate if they form or nucleate on the patterned substrate.

The asymmetric collapse of cavitating bubbles generates a pressure pulse which can damage the structures by e.g. breaking the structures. Cavitating bubbles can be prevented from nucleating on the patterned substrate comprising 3-dimensional topographical features if the cleaning solution is completely wetting these features. Not all the chemicals currently used in physical force assisted cleaning will achieve complete wetting of a dense pattern of features. By applying the method of the invention complete wetting of the patterned substrate by the cleaning solution is achieved.

As disclosed further in detail, two alternatives are recited to achieve complete wetting of the patterned substrate by the cleaning solution: according to the invention, (1) by supplying an additive to the surface to be cleaned, prior to supplying the cleaning solution, not according to the invention, (2) by supplying an additive to the surface, at the same time with the cleaning solution. In both cases the complete wetting is achieved before the physical-force (e.g. megasonic, aerosol spray) is turned on.

Various embodiments of the present invention disclose a method for reducing the damage induced by a physical force assisted cleaning process on a patterned substrate.

In other words, the present invention discloses a method for performing a physical force-assisted cleaning process on a patterned surface of a substrate, thereby reducing the damage induced by the physical force.

The degree of wetting of a surface by a liquid is defined as the extent to which a surface is covered by a liquid (when the liquid is dispensed onto the surface). A complete wetting of a surface by a liquid means that every part (area) of the surface is in direct contact with the liquid. The surface could be a non-uniform surface with or without topographical features (planar/non-planar), with a homogeneous or inhomogeneous surface composition.

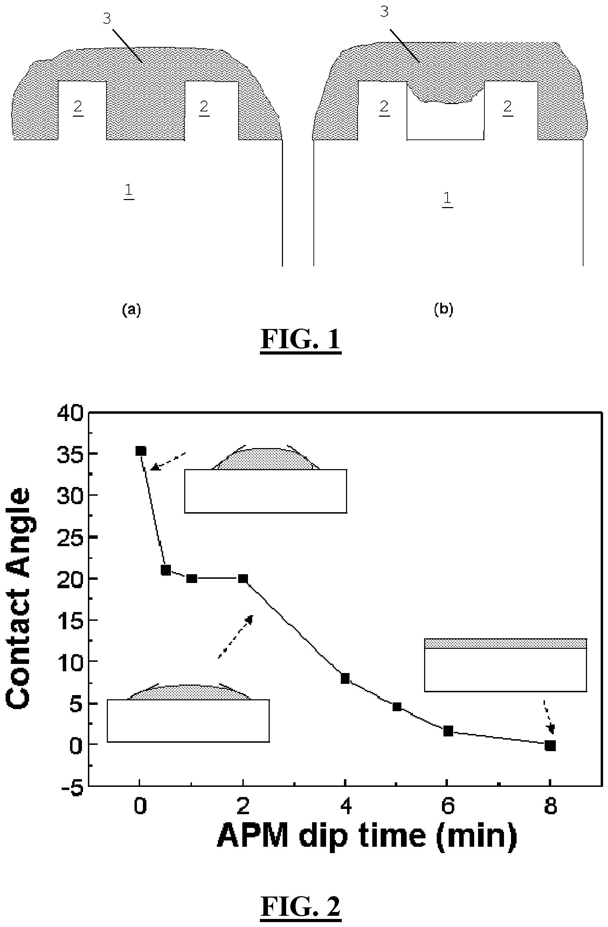

A high degree of wetting is obtained when total Gibbs free energy, $G_{interface}$, related to the interface solid (substrate)-liquid (in the configuration of complete wetting, as shown in Fig. 1 (a)) is low. The Gibbs free energy is obtained by summing up the products of solid-liquid surface tension ($\gamma_{SLi}$), times the surface area ($A_i$), for each different part of the entire solid-liquid interface as shown in the formula below:

$$G_{\mathrm{interface}} = \sum \gamma_{SLi} A_i$$

Wetting is partial if there is at least one location/area/feature on the surface where the liquid is not in direct contact with the surface. In this case, bubbles can easily form or nucleate on that location/area/feature of the surface enhancing the damage induced by the physical force assisted cleaning.

Consequently, a cleaning solution which is partially wetting the patterned substrate shows parts (areas, features) of the patterned substrate 1 (e.g. topographical features 2) which are not in direct contact with (or un-covered by) the cleaning solution 3 as illustrated in Figure 1 (b). A cleaning solution which is completely wetting the patterned substrate is in direct contact with every part (area) of the patterned substrate 1 (e.g. including the topographical features) as illustrated in Figure 1 (a).

In case of the flat surfaces (surface without topography), contact angle measurements can be used to evaluate the degree of wetting of a surface by a liquid. The contact angle is the angle at which a liquid/vapour interface meets the solid surface, measured at the vapour-side of the liquid vapour interface. The contact angle is specific for any given system and is determined by the interactions across the three interfaces. Most often the concept is illustrated with a small liquid droplet resting on a flat horizontal solid surface. If the liquid is very strongly attracted to the solid surface (for example water on a strongly hydrophilic substrate) the droplet will completely spread out on the solid surface and the contact angle (measured through the liquid) will be close to 0°. Less strongly hydrophilic solids will have a contact angle up to a value of typically 50°. On many highly hydrophilic substrates, water droplets will exhibit contact angles of 0° to 30°. If the solid substrate is hydrophobic, the contact angle will be larger than typically 60° or 70°. On highly hydrophobic substrates (referred to as "super-hydrophobic") water will have a contact angle as high as 150° or even nearly 180°. On these surfaces, water droplets simply rest (and are typically very mobile) on the surface, without actually wetting to any significant extent.

Typically a high degree of wetting of a surface by a liquid, corresponding to complete wetting as used herein below, is achieved when the contact angle is lower than or equal to 30°, preferably lower than 10°, more preferably close to 0°. A low degree of wetting of a surface by a liquid, corresponding to partial wetting as used herein below, is characterized by a contact angle higher than or equal to 50 degrees, preferably higher than 70 degrees.

The contact angle can also be measured in the the case of the substrates comprising topographical features or substrates with a non-homogenous surface distribution. In this case, the degree of wetting can be determined by experimental measurements of the contact angle or by estimating the contact angle using different theoretical models.

Among the experimental methods to determine the contact angle, most known are the static sessile drop method and the dynamic sessile drop method (contact angle hysteresis) employing high resolution cameras and software to capture and analyze the contact angle.

When the contact angle of a certain cleaning solution on a flat substrate is known, it is possible to estimate the wetting properties of a patterned substrate made of the same material. If a high contact angle (> 70 degrees) is measured on the flat surface then the cleaning solution is only partially wetting the patterned substrate as well.

However, when the contact angle is low (< 30 degree) and a complete wetting is achieved on the flat surface, one cannot make any statement about the wetting of a patterned substrate made of the same material. The cleaning solution might still show partial wetting of the patterned substrate, especially when the pattern comprises dense structures, i.e. structures characterized by a small pitch (i.e. sum of the structure line width and the spacing between two adjacent structures). Experimental measurements or theoretical calculations can be used to predict the wetting of the patterned substrate in this case. According to the preferred embodiment of the present invention, a 'substantially complete wetting' by a cleaning liquid of a patterned surface of a substrate to be cleaned, corresponds to a contact angle of less than 30°, as measured directly on the patterned surface, or as derived from theoretical models. For example, such a model may provide a relationship between the contact angle and contact time on a flat substrate on the one hand, and the contact angle and contact time on a patterned substrate of the same material on the other.

Various embodiments of the invention disclose a method for reducing the damage induced by a physical force assisted cleaning process on a patterned substrate.

Achieving a high degree of wetting, preferably a complete wetting of the substrate will have as effect a strong resistance for bubbles to form or nucleate on the substrate. This is particularly important for small topographical features of the substrate, e.g. lines with a width smaller than 45 nm. Because bubbles will not nucleate on these small features, less damage will be induced during the cleaning process.

In different embodiments of the invention, the physical force is acoustic agitation, provided to the cleaning solution in contact with the patterned substrate in the form of either ultrasonic or megasonic energy.

In alternative embodiments of the invention, the physical force is a mechanical agitation whereby bubbles or gas pockets are created in the cleaning solution in contact with the patterned substrate by e.g. aerosol spray. When treating the substrate with aerosol spray, multiple fine droplets of liquid (cleaning solution) are concurrently supplied to the substrate. In between the fine droplets 'gas pockets' or bubbles are created which will further behave in a similar way with the cavitating bubbles in a liquid during megasonic cleaning.

According to a first set of embodiments of the invention, the additive is supplied prior to step (b), by contacting the patterned surface of the substrate with the additive. In one embodiment, the additive is a liquid substance. In alternative embodiments the additive can be a vapour or a gas. After a certain contact time, enough to improve the degree of wetting of the patterned substrate by the cleaning solution (from partial wetting to complete wetting), the additive is removed and the cleaning solution is contacted with the patterned substrate. In other words, according to the invention, the surface is pre-treated by the additive.

Figure 2 represents the variation in contact angle of de-ionized water (DIW) on a Si hydrophobic substrate pre-treated with ammonia peroxide mixture (APM, $NH_4:H_2O_2:H_2O = 1:4:20$) as function of the APM-dip time. A reduction of the contact angle and a transition hydrophobic - hydrophilic is noticeable with increasing APM dip time. Alternatively similar reduction of contact angle can be obtained by applying water with dissolved $O_3$. These pretreatments are not illustrative of the invention. The initial high contact angle is due to organic contamination. The organic contamination may originate in the prolonged contact with cleanroom environment. It is worthy to mention that the contact time needed for the hydrophobic - hydrophilic transition can be much shorter, depending on the substrate, the pattern present on the substrate and the concentration of the additive used to modify the substrate condition. For example a contact time equal with the time interval needed to spin the additive on the substrate in a single wafer tool, e.g. 5 to 10s, can in some embodiments be enough.

The presence of organic contamination on the wafers stored in a cleanroom environment can increase the damage on the wafers during a subsequent megasonic cleaning/rinsing process. This increased risk for damage is prevented when the method of the invention is used.

In said first set of embodiments of the invention, the additive may be a liquid substance spun on the surface of a patterned substrate in a single wafer-tool during said contact time which is long enough to achieve complete wetting by the cleaning liquid. The additive may also be a vapour or a gas which is brought into contact with the patterned substrate. Alternatively, the additive is again a liquid substance, and the patterned substrate is immersed for a given time in said liquid substance in a batch processing tool, long enough to achieve (afterwards) complete wetting by the cleaning liquid. After that, the additive is removed from the substrate, and the cleaning liquid is supplied onto the surface by spinning the cleaning liquid in a single wafer tool, or the substrate is submerged in a container comprising the cleaning liquid, and a physical force is applied to thereby clean the substrate while in contact with the mixture, e.g. by a megasonic or aerosol-assisted cleaning process (as such known in the art, e.g. involving a piezo-electric element and a rod, thereby creating a liquid meniscus between the substrate and the vibrating rod, or involving a piezo-element in contact with said container).

According to a second set of variations not forming part of the invention, the additive is supplied during step (b), by mixing the additive with the cleaning solution, thereby improving the degree of wetting of the patterned substrate by the cleaning solution (from partial wetting to complete wetting). This can be done by preparing a mixture of the cleaning solution and the additive (e.g. DIW mixed with 10vol% IPA), and bringing the surface to be cleaned in contact with said mixture, during a time interval sufficient to achieve substantially complete wetting of the surface by said mixture. To perform this variation in a single wafer tool, a substrate is mounted on a supporting surface such as a rotatable chuck, and the mixture (cleaning liquid + additive) is spun onto the surface during a given time. After that, the physical force is applied and the substrate is cleaned while in contact with the mixture, e.g. by a megasonic or aerosol-assisted cleaning process (as such known in the art, e.g. involving a piezo-electric element and a rod, thereby creating a liquid meniscus between the substrate and the vibrating rod). In a batch cleaning tool, one or more substrates are submerged in a container comprising said mixture (cleaning liquid + additive), and maintained in said container sufficiently long so as to obtain complete wetting by said mixture of the surface to be cleaned. Subsequently, the physical force is applied in a manner - as such - known in the art, e.g. involving a piezo-transducer mounted in contact with the container.

The second set of variations not forming part of the invention, (i.e. wherein the additive is supplied during step (b)), also comprises variations wherein the additive is supplied to the surface to be cleaned, simultaneously with the supply of the cleaning liquid. In a single wafer tool, this can be done by spinning cleaning liquid and liquid additive simultaneously on the surface through separate nozzles. This supply of cleaning liquid and additive is continued during a given time, enough to mix the two liquids together and to obtain complete wetting of the surface by the mixture. After that, the physical force is applied and the substrate is cleaned while in contact with the mixture, e.g. by a megasonic or aerosol-assisted cleaning process (as such known in the art, e.g. involving a piezo-electric element and a rod, thereby creating a liquid meniscus between the substrate and the vibrating rod). In stead of liquid additive, gaseous additive may be supplied. Possibly, the supply of the additive may continue during the physical force, to ensure that the complete wetting-condition is maintained during the cleaning action. In a batch tool, the substrate may be submerged in a bath of cleaning liquid, while the additive is supplied to said bath, or directly to the surface of the substrate to be cleaned, through nozzles directed at said surface. The substrate is maintained in that manner sufficiently long for a complete wetting to take place. Subsequently, the physical force is applied in a manner - as such - known in the art, e.g. involving a piezo-transducer mounted in contact with the container. Here also, it is possible to continue supplying the additive, while the physical force is applied.

According to another set of embodiments, the pre-treatment described above according to any of the first set of embodiments is performed in combination with the mixed supply of the cleaning liquid and additive (either pre-mixed or simultaneously supplied), according to the second set of variations. This leads to a further reduction of substrate damage during physical force assisted cleaning, compared to the cases where only a pre-treatment is done, or compared to the case where only the mixed supply is provided.

According to any of the embodiments of the invention, the patterned surface is treated by an additive, in order to reduce the solid-liquid surface tension ($\gamma_{SL}$) between the surface and the cleaning liquid used. The cleaning liquid itself is not necessarily pre-treated : according to the first set of embodiments, the surface is pre-treated, and a standard cleaning liquid is used.

In some embodiments the additive is a liquid substance added to the cleaning solution. Alternatively, a vapour or a gas can be added to the cleaning solution.

The additive is a substance that can lower/decrease the surface tension at the solid-liquid interface between the substrate and the cleaning solution. This may be an alcohol selected from the group consisting of methanol, ethanol, n-propanol, isopropanol, n-butanol, isobutanol, or mixtures thereof. Preferably the substance that can lower the surface tension at the solid-liquid interface is isopropanol (i.e. isopropylalcohol or IPA). The concentration of IPA when used during step (b), as additive in the cleaning solution, varies between 10-20 vol%. When used as additive before step (b) according to the invention, higher concentrations (> 20 vol%) or pure IPA are preferred. Alternatively the substance that can lower the surface tension is acetone.

In alternative embodiments the substance that can lower the surface tension at the solid-liquid interface between the substrate and the cleaning solution is a surfactant. The surfactant is selected from the group consisting of (decyl)-, (n-octyl)-, (dodecyl)-trimethylammonium bromide, dodecylbenzenesulfonic acid sodium salt, lauryl sulfate sodium salt, octoxynol-5, octoxynol-9, octoxynol-30. cetylpriridinium bromide, Triton™ CF-10 (modified alkylaryl polyether), Triton™ CF-76 (modified aryl alkoxylate: 4-nonylphenoxy polyethoxy polypropoxy ethyl acetal) alkyloxypolyethyleneoxyethanol and mixtures or equivalents thereof. Preferably a surfactant concentration is between $10^{-5}$M to $10^{-2}$M. More preferably a surfactant concentration is between $10^{-5}$M to $10^{-3}$M.

According to the invention, the additive supplied prior to step (b) is isopropylalcohol (IPA) or acetone or a surfactant.

The patterned substrate can comprise any semiconductor material or mixture of semiconductor materials such as Si, Ge, SixGey, III-V compounds such as GaAs, InP, InSb, AlGaAs, InGaAs etc. The patterned substrate can be a bulk Silicon or a SOI (Silicon-on-insulator), a sSOI (stressed SOI) or a GOI (Germanium-on-insulator) substrate.

In particular embodiments of the invention the patterned substrate is a hydrophobic patterned silicon substrate. A typical example of hydrophobic silicon substrate is the "HF-last" substrate, i.e a silicon substrate subjected to a cleaning sequence having an aqueous treatment with hydrofluoric acid (HF) spiking as last step of the sequence (see also the Experimental section) .

In different embodiments of the invention the cleaning solution is an aqueous based solution.

In alternative embodiments of the invention the cleaning solution is a solvent-based solution. The solvent can comprise dimethyl sulfoxide (DMSO), n-ethyl pyrrolidone (NEP), 1-methoxy-2-propyl-acetate (PGMEA), n-methyl pyrrolidone (NMP), propylene-carbonates (PC) and combinations thereof. The HF-last treatment referred to above actually renders a silicon substrate 'philic' with respect to certain solvent-based cleaning liquids. Thus, the HF-last treatment is in fact a pre-treatment, when used in combination with a solvent-based cleaning liquid. Hydrofluoric acid (HF), or a solution comprising HF is thus also an additive that can be used in a method not forming part of the invention.

In particular embodiments the cleaning solution can be a rinsing solution. More specific, the rinsing solution can be de-ionized water.

Different embodiments of the invention disclose a method for reducing the damage induced by a megasonic assisted cleaning process on a patterned substrate.

The additive is supplied "prior to applying the megasonic power" which should be interpreted as prior to reaching a certain level in megasonic power (cavitation threshold) that would initiate bubbles cavitation in the cleaning solution. A very soft megasonic agitation, well below the cavitation threshold, may help in achieving a faster complete wetting of the patterned substrate by the cleaning solution.

In embodiments of the invention, additional chemicals can be spiked into the cleaning solution during applying the physical force to the patterned substrate in contact with the cleaning solution.

**Examples** not forming part of the invention

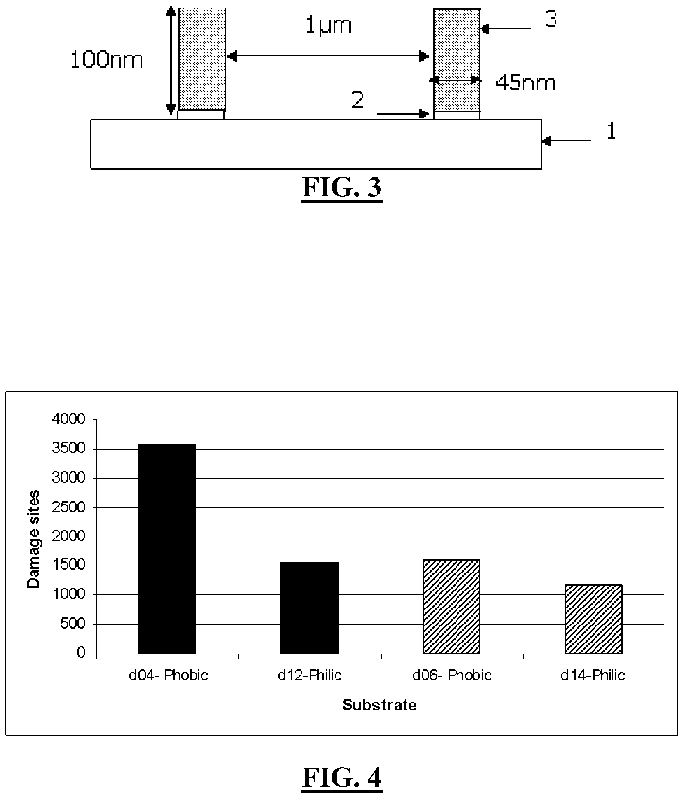

Different tests are performed on patterned silicon wafers with a cross section represented schematically in Fig 3.

Poly-silicon structures (3), used in devices as gate electrodes, with a post etch line width of 45 nm and a spacing of about 1 micron were defined on a bulk silicon substrate (1) with a thin oxide layer (2) typically present as gate oxide in between the polysilicon structures and the substrate.

The megasonic assisted cleaning experiments are performed on both hydrophobic and hydrophilic substrates (wafers) in a single wafer (SW) cleaning tool (Goldfinger Akrion®) and in a batch cleaning (WB) tool. The single wafer system consists of a spinning chuck with the wafer held horizontally. The sound energy is transferred from the piezoelectric material through a quartz rod and liquid meniscus to the wafer. The cleaning solution is de-ionized water (DIW) or DIW containing 10 vol% isopropyl alcohol (IPA). The megasonic power settings are between 10W and 30W for the single wafer tool and between 100W and 1200W for the batch tool. The substrates are cleaned for 30 to 120 seconds. The conditions for each sample are summarized in Table 1.

Table 1

| Wafer Label | Surface pre-treatment | Surface condition | Megasonic power (W) | Cleaning solution | Cleaning tool | Damage sites (a.u.) |
|---|---|---|---|---|---|---|
| d04 | HF-last | Phobic | 30 | DIW | SW | 3562 |
| d04 | HF-last | Phobic | 15 | DIW | SW | 957 |
| d04 | HF-last | Phobic | 10 | DIW | SW | 642 |
| d08 | HMDS-coating | Phobic | 30 | DIW | SW | 1814 |
| d12 | O3-last | Philic | 30 | DIW | SW | 1551 |
| d12 | O3-last | Philic | 15 | DIW | SW | 603 |
| d12 | O3-last | Philic | 10 | DIW | SW | 144 |
| d06 | HF-last | Phobic | 30 | DIW+IPA | SW | 1616 |
| d10 | HMDS-coating | Phobic | 30 | DIW+IPA | SW | 1696 |
| d14 | O3-last | Philic | 30 | DIW+IPA | SW | 1168 |
| x11 | O3-last | Philic | 100 | DIW | WB | 2833 |
| x10 | O3-last | Philic | 1200 | DIW | WB | 3656 |
| x12 | HF-last | Phobic | 100 | DIW | WB | 3589 |
| x13 | HF-last | Phobic | 1200 | DIW | WB | 25658 |

The hydrophobic wafers, referred herein below as "HF-last" or "phobic" samples, were prepared by subjecting the patterned wafers to a "HF-last clean" before the megasonic assisted clean. The "HF-last clean" is a cleaning sequence comprising first an oxidation step using ozone and de-ionized water (O3/DIW), followed by an oxide removal step using HF/HCl and a rinsing step with de-ionized-water and HCl spiking.

Another type of hydrophobic wafers are prepared by spinning HMDS (hexamethyldisilazane). These samples are referred below as HMDS-coated wafers.

The hydrophilic wafers, referred herein below as 'chemical oxide' or "philic" samples, were prepared by subjecting the patterned wafers first to a "O3-last clean" before applying the megasonic assisted clean. The "O3-last clean" is a cleaning sequence comprising first an oxidation step using ozone and de-ionized water (O3/DIW), followed by an oxide removal step using HF/HCl and a rinsing in ozonated de-ionized-water (O3/DIW). A SiO2 chemical oxide with a thickness of about 0.7 nm is typically formed on the substrates. The 'philic' samples are thus 'phobic' samples that have received a pre-treatment.

The defect sites are evaluated with a brightfield pattern inspection tool (KLA Tencor 2800®) before and after the megasonic assisted cleaning.

The number of defect sites added by the megasonic assisted cleaning are calculated by subtracting for each size bin (i.e. window in the particle size distribution) the initial number of defects (before the megasonic assisted cleaning) from the final number of defects (after the megasonic assisted cleaning).

A typical method of doing pattern damage inspection is described as follows. Every step during the semiconductor device fabrication can lead to defect generation. By defects we mean pattern damage / broken lines/ residues/ particles etc. To evaluate the number of defects generated during a particular process step the wafers critical regions are inspected with a brightfield tool before the process is carried out. Once the process has been carried out it is inspected a second time with the brightfield tool. The brightfield tool is programmed in such a way that it will always inspect the same region of interest(ROI). The first defect inspection result is then subtracted from the second one to arrive at the defect adders. These defect adders can be further verified with a review SEM if required.

Figure 4 represents the number of damage sites for hydrophobic (d04 and d06) and hydrophilic (d12 and d14) patterned wafers after applying a megasonic assisted cleaning (400KHz-3MHz, 30W) in de-ionized water DIW (d04 and d12) and, respectively in DIW with IPA addition (d06 and d14).

The histogram in Fig 4 shows that the number of damage sites after a megasonic assisted cleaning in DIW depends strongly on the substrate condition. For the phobic sample (d04) 3562 adders (added defects) were counted, while for the philic substrate (d12) 1551 adders were found. By adding IPA (10 vol%) to DIW and applying a megasonic cleaning with the same settings we notice both on the phobic (d06) and on the philic (d14) wafers a decrease in the number of adders to 1616 and, respectively, to 1168. The decrease is more important for the phobic substrate (45% of the initial adders). It is to be noted in particular that the use of IPA in the cleaning liquid, in addition to the pre-treatment of the substrate causes an additional decrease in the number of defect sites. This is illustrated by the results of samples d12 and d14.

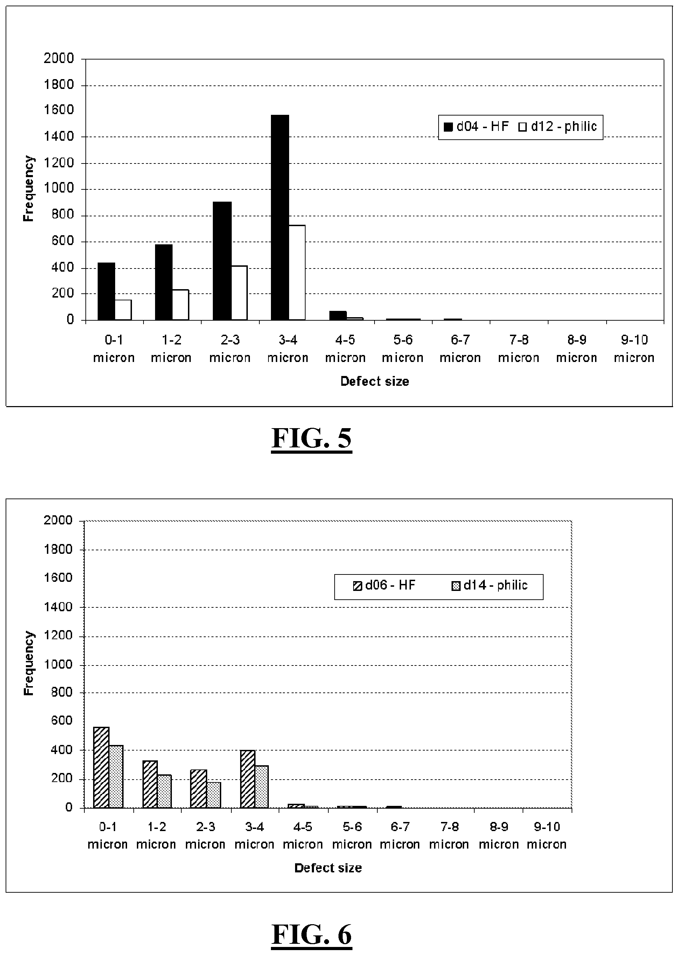

Figures 5 and 6 show important differences in the defect size distribution between the megasonic cleaning in DIW and the same megasonic cleaning in DIW with IPA addition. The differences are more pronounced for the hydrophobic wafers.

For example, Fig 5 shows a very high amount of big size defects (2-3 micron and 3-4 micron) especially on the hydrophobic wafer (d04) subjected to megasonic cleaning in DIW. Figure 6 shows an important decrease of the above mentioned big size defects for both the phobic (d06) and the philic (d14) samples subjected to megasonic cleaning in DIW with IPA addition. The important decrease observed confirms the reduced damage (less broken structures) of the megasonic cleaning with a cleaning solution which is wetting the substrate.

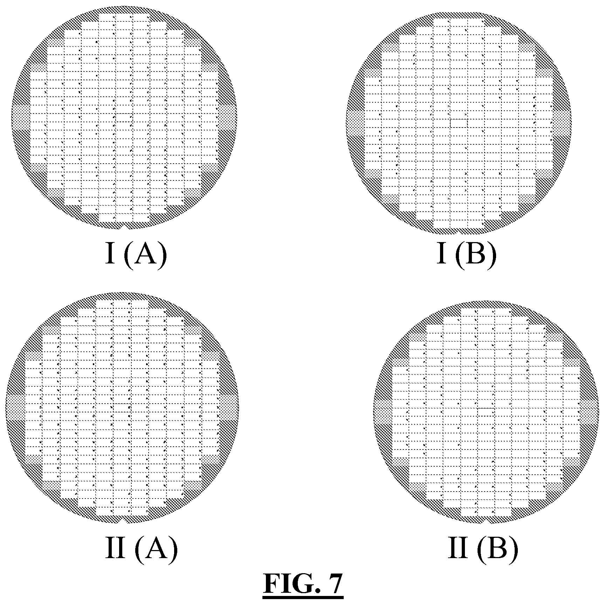

Fig 7 shows different defect maps for the added defects (2.5-3 micron) after a megasonic cleaning, as follows: I(A) philic substrate in DIW; I(B) philic substrate in DIW + IPA; II(A) phobic substrate in DIW; II(B) phobic substrate in DIW + IPA. It is worthy to notice that the number of dies affected in case of a phobic substrate is much higher that in case of a philic substrate. Adding IPA to achieve complete wetting before applying megasonic cleaning, not only reduces the number of defects as shown in Figs 5 to 7, but also reduces the number of dies affected.

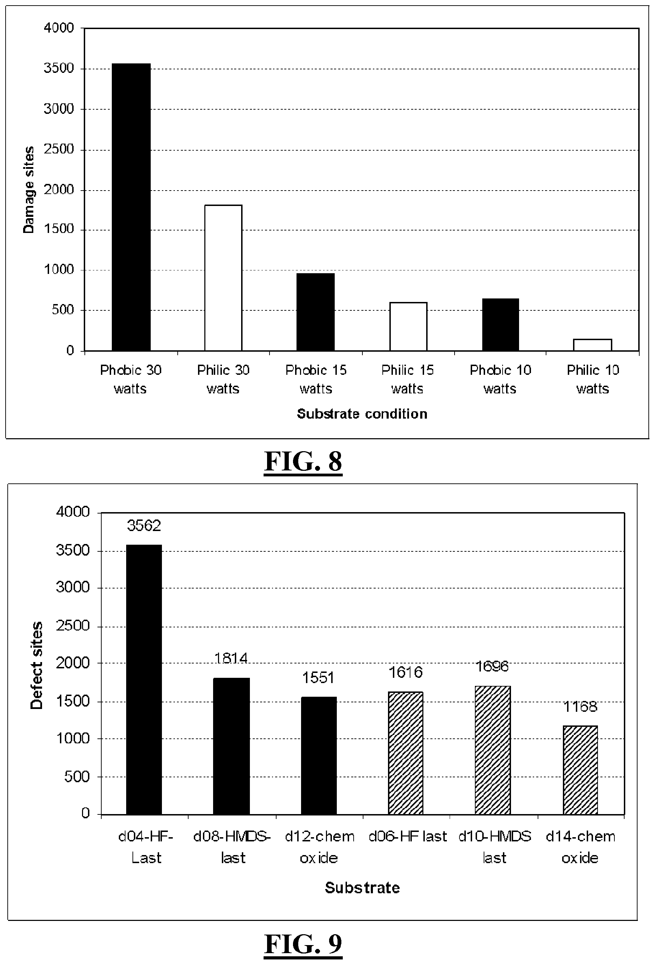

Figure 8 represents the number of damage sites for hydrophobic and hydrophilic patterned wafers after applying a megasonic assisted cleaning in DIW at different megasonic power settings: 30W, 15W and 10 W. At higher power settings the difference in the number of damage sites between phobic and philic becomes more pronounced. Completely wetting the substrate by the cleaning solution when applying megasonic is more stringently needed at higher power levels.

Even at low power levels the damage on the phobic substrates is significant and it will become more critical when decreasing the features size or when fabricating high aspect ratio features, e.g. fin structures in FinFET devices.

Figure 9 represents the number of damage sites for hydrophobic and hydrophilic patterned wafers after applying a megasonic cleaning (400KHz-3MHz, 30 W) in DIW (d04, d08, d12) and in DIW with IPA addition (d06, d10, d14).

The HF-last (d04, d06) substrates and the chemical oxide (d12, d14) samples have been plotted in Fig 4 as well, while the HMDS-coated substrates (d08, d10) are two other examples of hydrophobic substrates. HMDS is a known primer material used in photolithography, with hydrophobic properties. The relative low number of defect sites in case of HMDS-coated substrates (after megasonic clean in DIW) can be explained by an incomplete coverage with HMDS. However, in the case of HMDS-coated substrates too, a decrease in the number of defects sites is observed when applying megasonic in DIW with IPA addition.

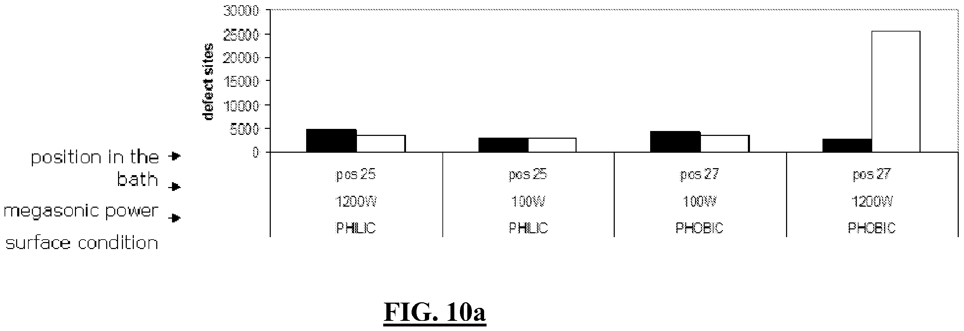

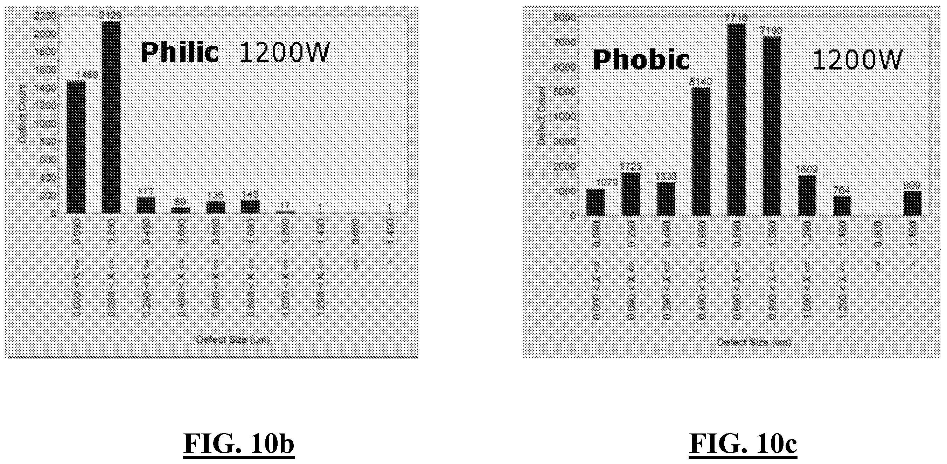

Figure 10 (a) represents the number of damage sites for hydrophobic and hydrophilic patterned wafers after applying a megasonic cleaning (400KHz-3MHz) at 100W and 1200W in DIW in a batch processing tool. Figure 10 (b) represents the defect size distribution for the philic wafers at 1200 W in DIW and Fig 10 (c) the defect size distribution for the phobic wafers at 1200 W in DIW.

As shown in Fig 10(a) the damage level after high power (1200W) megasonic rinse (2 min) on phobic substrates is about 7 times higher than same conditions on philic substrates. The black columns in the histogram show the number of damage sites after the O3-last or HF-last pre-clean, while the white columns show the number of damage sites after megasonic rinse in DIW. The high level of damage of the hydrophobic substrates is confirmed for the batch processing with the 25658 adders measured.

As shown in Figs 11(b) and (c), in case of the phobic substrates, more than 80% of the defects are bigger than 0.7 micron, while for philic substrates more than 90% defects are smaller than 0.7 micron. The size distribution of the measured defects confirms the high level of damage (most probably originating in the broken lines) on the phobic substrates.

The foregoing embodiments can be applied in different areas of semiconductor device manufacturing.

**Claims**

1. A method for performing a physical force-assisted cleaning process on a patterned surface of a substrate (1), comprising :

   a) providing a substrate having at least one patterned surface,
   b) supplying a cleaning liquid (3) to the patterned surface,
   c) applying a physical force to the cleaning liquid in contact with the patterned surface, whereby the physical force leads to bubble formation in the cleaning liquid,

   wherein :
   prior to applying the physical force, an additive is supplied to said patterned surface, and said additive is maintained in contact with said patterned surface for a given time, said additive and said time being chosen so that substantially complete wetting of the patterned surface by the cleaning liquid is achieved and wherein

   - the patterned surface comprises line features having a linewidth smaller than or equal to 45nm,
   - the additive is supplied prior to step (b), by contacting the patterned surface of the substrate with the additive,
   - the additive is isopropylalcohol (IPA) or acetone or a surfactant
   - the additive is removed from the substrate prior to the step of supplying a cleaning liquid.

2. The method according to claim 1, wherein said additive and said time are chosen so that the contact angle of the cleaning liquid on said patterned surface is smaller than 30°.

3. The method according to claim 1 or 2, wherein the physical force is an acoustic agitation provided by a megasonic energy source.

4. The method according to claim 1 or 2, wherein the physical force is a mechanical agitation provided by an aerosol spray.

5. The method according to any one of the preceding claims, wherein the cleaning liquid is de-ionized water.

6. The method according to any one of claims 1 to 4, wherein the cleaning liquid is a solvent-based solution.

7. The method according to any one of the preceding claims, wherein said additive is a liquid.

8. The method according to any one of claims 1 to 7, wherein said additive is a vapour or a gas.

**Patentansprüche**

1. Verfahren zum Durchführen eines mit physischer Kraft unterstützten Reinigungsprozesses auf einer gemusterten Fläche eines Substrats (1), umfassend

   a) Bereitstellen eines Substrats mit mindestens einer gemusterten Fläche,
   b) Liefern einer Reinigungsflüssigkeit (3) an die gemusterte Fläche,
   c) Anwenden einer physischen Kraft auf die Reinigungsflüssigkeit in Kontakt mit der gemusterten Fläche, wobei die physische Kraft zur Blasenbildung in der Reinigungsflüssigkeit führt, wobei
   vor dem Anwenden der physischen Kraft ein Zusatzstoff an die gemusterte Fläche geliefert wird und der Zusatzstoff mit der gemusterten Fläche für eine bestimmte Zeit in Kontakt gehalten wird, wobei der Zusatzstoff und die Zeit so gewählt werden, dass das im Wesentlichen vollständige Befeuchten der gemusterten Fläche durch die Reinigungsflüssigkeit erzielt wird, und wobei

   - die gemusterte Fläche Zeilenmerkmale umfasst, die eine Zeilenbreite von weniger oder gleich 45 mm aufweisen,
   - der Zusatzstoff vor Schritt (b) geliefert wird, indem die gemusterte Fläche des Substrats mit dem Zusatzstoff in Kontakt gebracht wird,
   - der Zusatzstoff Isopropylalkohol (IPA) oder Aceton oder ein Tensid ist
   - der Zusatzstoff vom Substrat vor dem Schritt des Lieferns einer Reinigungsflüssigkeit entfernt wird.

2. Verfahren nach Anspruch 1, wobei der Zusatzstoff und die Zeit derart gewählt werden, dass der Kontaktwinkel der Reinigungsflüssigkeit auf der gemusterten Fläche kleiner als 30° ist.

3. Verfahren nach Anspruch 1 oder 2, wobei die physische Kraft eine akustische Agitation ist, die von einer Megaschall-Energiequelle bereitgestellt wird.

4. Verfahren nach Anspruch 1 oder 2, wobei die physische Kraft eine mechanische Agitation ist, die von einem Aerosolspray bereitgestellt wird.

5. Verfahren nach einem der vorhergehenden Ansprüche, wobei die Reinigungsflüssigkeit deionisiertes Wasser ist.

6. Verfahren nach einem der Ansprüche 1 bis 4, wobei die Reinigungsflüssigkeit eine Lösemittel-basierte Lösung ist.

7. Verfahren nach einem der vorhergehenden Ansprüche, wobei der Zusatzstoff eine Flüssigkeit ist,

8. Verfahren nach einem der Ansprüche 1 bis 7, wobei der Zusatzstoff ein Dampf oder ein Gas ist.


**Revendications**

1. Procédé d'exécution d'un processus de nettoyage assisté par une force physique sur une surface structurée d'un substrat (1), comprenant :

   a) le fait de prévoir un substrat ayant au moins une surface,
   b) la fourniture d'un liquide de nettoyage (3) à la surface,
   c) l'application d'une force physique au liquide de nettoyage en contact avec la surface, moyennant quoi la force physique engendre la formation de bulles dans le liquide de nettoyage,
   dans lequel :
   avant l'application de la force physique, un additif est fourni à ladite surface, et ledit additif est maintenu en contact avec ladite surface pendant une durée donnée, ledit additif et ladite durée étant choisis de sorte qu'une humidification sensiblement complète de la surface par le liquide de nettoyage soit effectuée, et dans lequel

   - la surface comprend des lignes ayant une largeur supérieure ou égale à 45 nm,
   - l'additif est fourni avant l'étape (b), en mettant en contact la surface du substrat avec l'additif,
   - l'additif est de l'alcool isopropylique (IPA) ou de l'acétone ou un tensioactif,
   - l'additif est retiré du substrat avant l'étape de fourniture d'un liquide de nettoyage.

**2.** Procédé selon la revendication 1, dans lequel ledit additif et ladite durée sont choisis de sorte que l'angle de contact du liquide de nettoyage sur ladite surface soit inférieur à 30°.

**3.** Procédé selon la revendication 1 ou 2, dans lequel la force physique est une agitation acoustique assurée par une source d'énergie mégasonique.

**4.** Procédé selon la revendication 1 ou 2, dans lequel la force physique est une agitation mécanique assurée par un aérosol.

**5.** Procédé selon l'une quelconque des revendications précédentes, dans lequel le liquide de nettoyage est de l'eau désionisée.

**6.** Procédé selon l'une quelconque des revendications 1 à 4, dans lequel le liquide de nettoyage est une solution à base de solvant.

**7.** Procédé selon l'une quelconque des revendications précédentes, dans lequel ledit additif est un liquide.

**8.** Procédé selon l'une quelconque des revendications 1 à 7, dans lequel ledit additif est une vapeur ou un gaz.

**FIG. 1**

**FIG. 2**

**FIG. 3**

**FIG. 4**

**FIG. 5**

**FIG. 6**

I (A)

I (B)

II (A)

II (B)

**FIG. 7**

**FIG. 8**

**FIG. 9**

**FIG. 10a**

EP 2 226 834 B1

**FIG. 10c**

**FIG. 10b**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0810643 A2
- US 2006042651 A1
- JP 2007150164 A
- US 6124214 A
- JP 2008085150 A

### Non-patent literature cited in the description

- **VEREECKE G et al.** Removal of nano-particles by mixed-fluid jet: evaluation of cleaning performance and comparison with megasonic. *SOLID STATE PHENOMENA,* 2008, vol. 134, 193-196
- **HAGIMOTO Y et al.** The effective damage-free megasonic cleaning using N2 dissolved APM. IEEE, 2005, 215-218